Europäisches Patentamt

European Patent Office

Office européen des brevets

(19)

(11) Publication number: **0 181 177 B1**

(12) **EUROPEAN PATENT SPECIFICATION**

(45) Date of publication of patent specification: **27.02.91**  (51) Int. Cl.5: **G11C 7/00**

(21) Application number: **85307971.3**

(22) Date of filing: **04.11.85**

(54) A semiconductor memory device.

(30) Priority: **05.11.84 JP 232733/84**

(43) Date of publication of application:
**14.05.86 Bulletin 86/20**

(45) Publication of the grant of the patent:
**27.02.91 Bulletin 91/09**

(84) Designated Contracting States:
**DE FR GB**

(56) References cited:
**EP-A- 0 017 990**
**EP-A- 0 074 206**
**US-A- 4 165 541**

(73) Proprietor: **FUJITSU LIMITED**
**1015, Kamikodanaka Nakahara-ku**
**Kawasaki-shi Kanagawa 211(JP)**

(72) Inventor: **Nozaki, Shigeki**
**Mezonhisasue 203, 473-4 Hisasue Takatsu-ku**
**Kawasaki-shi Kanagawa 213(JP)**
Inventor: **Ohira, Tsuyoshi**
**Kurashinokyoshitsu 102 125, Mizonokuchi**
**Takatsu-ku Kawasaki-shi Kanagawa 213(JP)**
Inventor: **Satoh, Masaru**
**Sanihausu 205 5-9-5, Yako Tsurumi-ku**
**Yokohama-shi Kanagawa 230(JP)**
Inventor: **Nakano, Tomio**
**12-404, 1-11-2, Shirahatadai Miyamae-ku**
**Kawasaki-shi Kanagawa 213(JP)**
Inventor: **Takemae, Yoshihiro**
**8-13-24-303, Akasaka Minato-ku**
**Tokyo 107(JP)**

(74) Representative: **Billington, Lawrence Emlyn et al**
**HASELTINE LAKE & CO Hazlitt House 28**
**Southampton Buildings Chancery Lane**
**London WC2A 1AT(GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

The present invention relates to a semiconductor memory and particularly, but not necessarily exclusively, to an input circuit which receives an external control signal such as a $\overline{WE}$ (write enable bar) signal.

One type of semiconductor memory-device comprises an input circuit which is connected to a reference potential line connectable to an external power source and which includes a MOS transistor receiving an external control signal such as $\overline{WE}$ (a write enable bar) signal at a TTL level. The input circuit outputs an inverted MOS level signal in accordance with a high level or a low level of the external control signal. This semiconductor memory device further provides an output stage transistor which is connected to the reference potential line and which generates a low or high level output by turning the output stage ON.

As external control signals of a semiconductor memory device, signals such as $\overline{RAS}$ (Row address strobe), $\overline{CAS}$ (Column address strobe), $\overline{OE}$ , and $\overline{WE}$ having a TTL level are used for controlling the mode or timing of operation of internal circuits in the device, memory cells are accessed by receiving these signals and address signals, and read and write operations are carried out for the memory cells. The present invention is concerned with an input circuit for these external control signals, particularly $\overline{WE}$ signals. For example, this input circuit, which receives a TTL level signal supplied to an input terminal, has a high level of 2.4 V or more and a low level of 0.8 V or less and converts the same to a MOS level having a high level power source voltage $V_{CC}$(5 V) or a low level power source voltage $V_{ss}$(0 V), and activates a clock generator circuit for carrying out a specific operation mode by signals output after the level is converted.

When, for example, the $\overline{WE}$ signal is at a H (high) level, the memory is in read out mode, and data in the memory cell selected by address signals is read out externally.

In the circuit as mentioned above, when the output stage transistor is turned ON to make the output level low or high, a comparatively large current flows via the output stage transistor to or from the reference potential line. As the wire for forming the reference potential line has a resistance, then the potential level of the reference potential line rises or falls when the large current flows via the output stage transistor thereto or therefrom.

On the other hand, the TTL level input signal, for example, the $\overline{WE}$ signal has a constant level with respect to the external ground level, that is, lower than 0.8 V for the low level and higher than 2.4 V for the high level with reference to the external ground level. Thus, when the reference potential level inside the device which should be held at the ground level rises due to the large current at the output stage, the input stage transistor receiving an input of the TTL high level may not turn ON, so that the input circuit sometimes cannot output a low level output, as explained in detail hereinafter. When the output of the input circuit is not at the L level, a writing mode is operative, and it is possible for the writing circuit inside the device to operate and the memory carry out a write operation. Further, the writing circuit provides a latch function, and thus when the H level output is once generated, this is latched and a writing error may occur.

When the input logic level is defined with respect to the reference potential level supplied by the high level power source voltage unlike the above case, the falling of the potential at the reference potential line inside the device accompanied by the high level output at the output stage may cause a similar malfunction at the input stage.

EP-A-O 074 206 discloses a semiconductor memory device having the features of the precharacterising part of accompanying claim 1.

According to the present invention, there is provided a semiconductor memory device operatively connectable to a power source including:

a reference potential line operatively connected to receive a reference potential from said power source;

an input circuit connected to said reference potential line and receiving an external input signal having a logic level defined in reference to said reference potential to be supplied to said reference potential line;

an output circuit having an external output terminal, connected to said reference potential line, for generating an output indicative of read-out data from the memory device to said external output terminal; characterised by:

the generation of the output being initiated at a delay time after a read access to the memory device is made and thereafter the output being maintained; and by

an inhibiting circuit for inhibiting a response to said external input signal of said input circuit for a predetermined period during which the generation of the output is initiated at said delay time after said read access, the input circuit being enabled thereafter.

An embodiment of the present invention may remove the above-mentioned drawbacks and prevent malfunction of the input circuit even when the potential of the reference potential line inside the device is caused to rise or fall by the output current.

Reference is made, by way of example, to the accompanying drawings in which:

Figure 1 is a block diagram of a semiconductor memory device to which the present invention may be applied;

Figs. 2A and 2B are diagrams of an example of an output stage circuit of a data output buffer;

Fig. 3 is a diagram showing waveforms for explaining the operation of the circuit shown in Fig. 2;

Fig. 4 is a diagram showing one embodiment of a circuit according to the present invention;

Fig. 5 is a diagram showing an embodiment of a circuit for generating a signal $\phi_D$ used in the circuit shown in Fig. 4; and

Figs. 6 and 7 are diagrams showing waveforms explaining the operation of the circuit shown in Figs. 4 and 5.

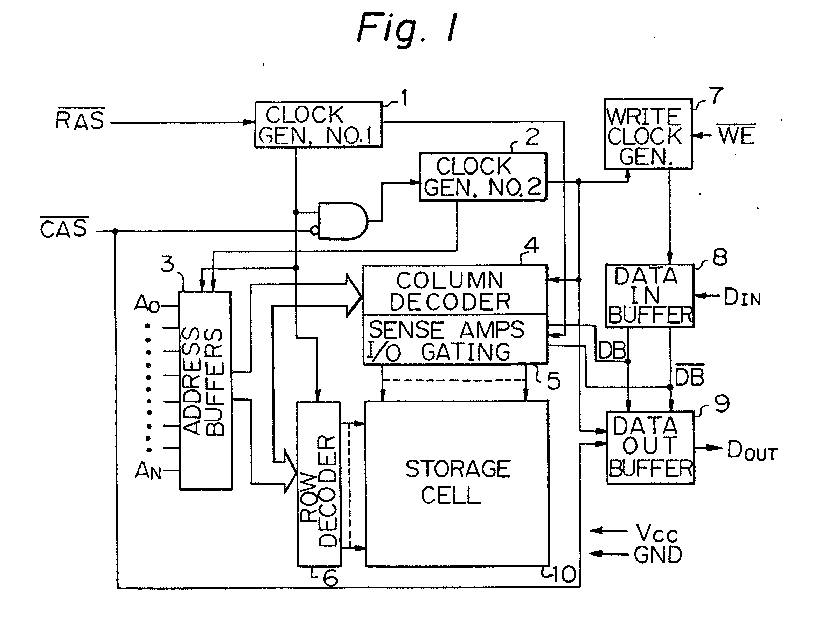

Figure 1 is a block diagram of a semiconductor memory device, such as a MOS type memory, to which the present invention may be applied.

In Fig. 1, $\overline{RAS}$ denotes a row address strobe, $\overline{CAS}$ a column address strobe, $A_0$ to $A_N$ address input terminals, $\overline{WE}$ a write enable bar signal, $D_{IN}$ a data input, and $D_{OUT}$ a data output. Further, reference numerals 1 and 2 designate clock generators, reference numeral 3 designates address buffers, reference numerals 4 and 5 designate a column decoder and a sense amplifier respectively, reference numeral 6 designates a row decoder, reference numeral 7 designates write clock generators, reference numeral 8 designates a data-in buffer, reference numeral 9 designates a data-out buffer, reference numeral 10 designates a storage cell. The clock generator 1 generates a clock for operating the sense amplifier 5 and the row decoder 6, and the clock generator 2 generates a clock for operating the column decoder 4, the write clock generator 7, and the data-out buffer 9. The semiconductor memory device receives external control signals such as $\overline{RAS}$ , $\overline{CAS}$ , and $\overline{WE}$ , and the storage cell 10 is accessed and a read or write operation is carried out for the cell.

The present invention is explained below by way of an example wherein an input circuit for the $\overline{WE}$ signal is provided with means for preventing the aforesaid malfunction in accordance with an embodiment of the present invention. Such an input circuit is included in the write clock generator 7 and receives the $\overline{WE}$ signal having a TTL level, that is, the high level thereof is 2.4 V or more and the low level thereof is 0.8 V or lower. In the input circuit, this TTL level is converted to a MOS level signal, that is, having a high level that is the same as that of the high power source $V_{CC}$(5 V), a low level that is the same as that of the low power source $V_{SS}$(0), and the write clock generator 7 is operated by this converted output.

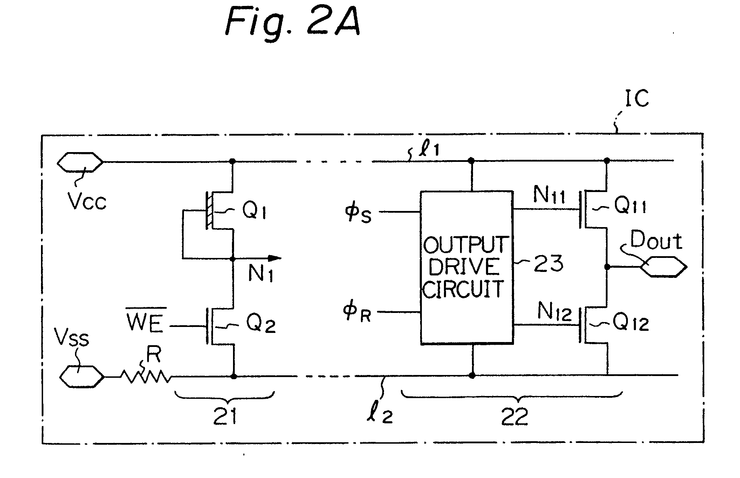

When $\overline{WE}$ signal is at a H (high) level, the memory is in the read out mode, and data in the memory cell selected by address signals is read out externally. Figure 2A shows an output stage of the data output buffer and an input circuit of the $\overline{WE}$ signal, wherein 21 designates the input circuit and 22 designates the output stage. These circuits are connected to the high potential line $\ell_1$ of the power source and the low potential line $\ell_2$ of the power source, the latter used as a reference potential line in a TTL logic level system. The input circuit includes a depletion type MOS transistor $Q_1$ , in which a gate and a source are short-circuited, and an enhancement type MOS transistor $Q_2$ connected to the transistor $Q_1$ in series. The input circuit is formed as an inverter having a series-connected point $N_1$ as an output terminal. The input $\overline{WE}$ signal enters a gate of the transistor $Q_2$ , and when the input signal is H level and exceeds the threshold value of the transistor $Q_2$ , the transistor $Q_2$ turns ON and the output, that is, the level at the node $N_1$ becomes L level ($V_{SS}$). When the input signal is low level and below the threshold level of the transistor $Q_2$ , the transistor $Q_2$ turns OFF, and the output becomes H level ($V_{CC}$). This threshold level is set at an intermediate level between the TTL low and high levels, for example, at 1.6 V.

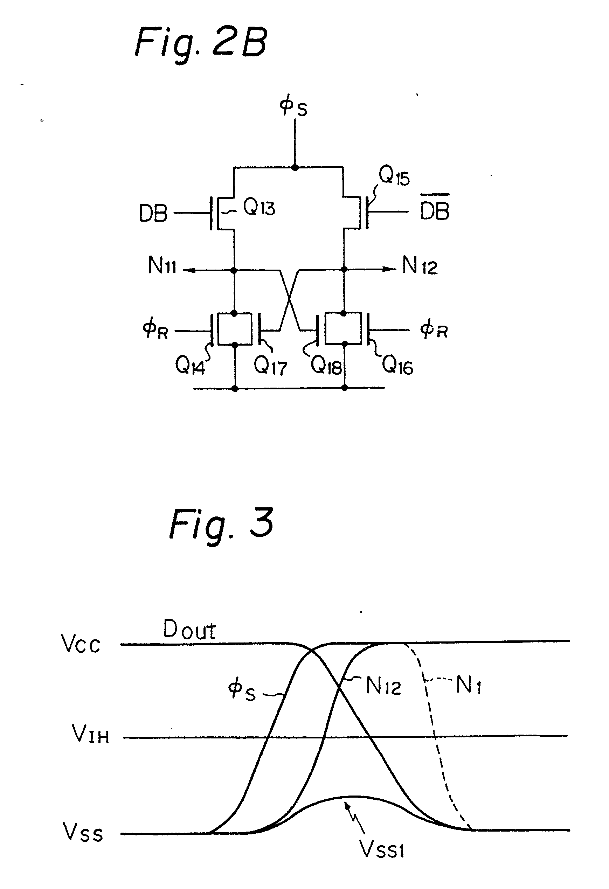

The output stage 22 includes an output circuit having enhancement type MOS transistors $Q_{11}$ , $Q_{12}$ connected in series, and a series-connected point used as an output terminal $D_{OUT}$ and an output drive circuit 23 thereof. The output drive circuit may be formed as shown in Fig. 2B. In Fig. 2B, transistors $Q_{13}$ to $Q_{18}$ are MOS transistors, and $\phi_S$ and $\phi_R$ are set and reset clocks for operating the drive circuit 23. Cell data DB and $\overline{DB}$ are supplied from the sense amplifier 5 (shown in Fig. 1) to the gate of the transistors $Q_{13}$ and $Q_{15}$ respectively. In Fig. 2B, the transistors $Q_{17}$ and $Q_{18}$ for forming a latch and reset transistors $Q_{14}$ and $Q_{16}$ are provided so that the circuit is operated in a stabilized condition, therefore these transistors are not always necessary.

When the set clock $\phi_S$ rises and the cell data is "1", that is, DB = high and $\overline{DB}$ = low, the signal at node $N_{11}$ between the transistors $Q_{13}$ and $Q_{14}$ becomes H (high) level and the signal at node $N_{12}$ between the transistors $Q_{15}$ and $Q_{16}$ becomes L (low) level. These signal levels at nodes $N_{11}$ and $N_{12}$ are maintained until the latch is reset by the reset transistors $Q_{14}$ and $Q_{16}$ by reset clock $\phi_R$. Meanwhile, the transistor $Q_{11}$ turns ON and the transistor $Q_{12}$ turns OFF (Fig.2A), so that the output $D_{OUT}$ (herein the node and its level are shown by the same symbol) is H level ($V_{CC}$). When the data in the cell is "0" and the clock $\phi_S$ rises, the output signal $N_{12}$ of the driving circuit 22 becomes H, $N_{11}$ becomes L, the transistor $Q_{11}$ turns OFF,

and the transistor $Q_{12}$ turns ON, so that the output $D_{OUT}$ becomes L level ($V_{SS}$). Thus, the output drive circuit 23 receives the data read out by the clock signal $\phi_S$ and holds the data until the reset signal $\phi_R$ is received, and continuously drives the output circuit.

When the transistor $Q_{12}$ turns ON and the output $D_{OUT}$ becomes L, current flows along the path $D_{OUT}$, $Q_{12}$, and $V_{SS}$. The wiring of the power source line includes a resistance, shown by R in Fig. 2A. When the transistor $Q_{12}$ at the output stage turns ON, the current flowing along the path mentioned above is comparatively large, and the phenomenon occurs whereby the voltage level at the wiring $l_2$ of $V_{SS}$ rises from $V_{SS}$, that is, 0 V, due to the resistance mentioned above. $V_{SS1}$ in Fig. 3 shows this rise in the level of the wiring of $V_{SS}$. On the other hand, the $\overline{WE}$ signal may only be as high as slightly lower than 0.8 V for indicating L level ($V_{IL}$) and may only be as low as slightly higher than 2.4 V for indicating

H level ($V_{IH}$), in the TTL logic level system. The input transistor $Q_2$ can be turned on only when the difference between the input level at its gate ($\overline{WE}$ signal) and the internal $V_{SS}$ level applied to its source exceeds the threshold value of for example, 1.6 V. So, if the level at the wiring $l_2$ of $V_{SS}$ rises, the transistor $Q_2$ may not turn ON, even when the $\overline{WE}$ signal is at the H level, so that the problem occurs wherein the node $N_1$ does not (cannot) generate an L output. When the output $N_1$ of the input circuit is not L level, that is, at H level, the device is in the writing mode, and it is possible for the writing circuit in the device to operate and for the memory to carry out (only) the writing operation. Further, the writing circuit (not shown in the drawing) provides a latch function, so that, when the H level output is once generated, this is latched and an writing error (unwanted writing operation) may occur.

The present invention can remove or mitigate this problem, and malfunction of the $\overline{WE}$ input circuit may be prevented when the potential of the wiring line $l_2$ of $V_{SS}$ is caused to rise by the output current.

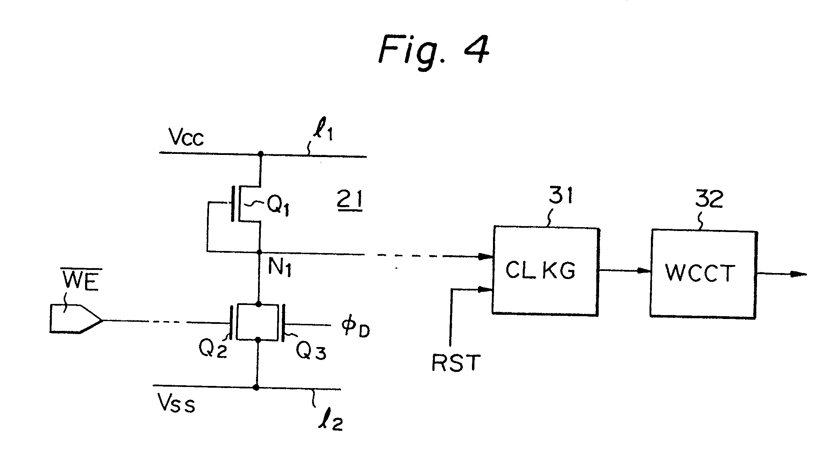

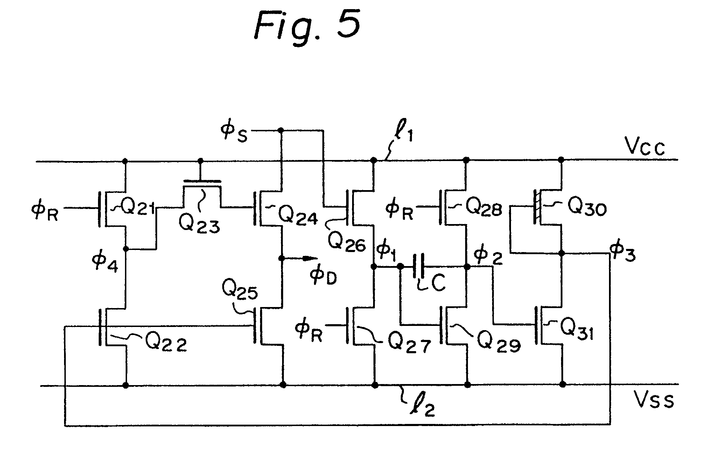

An embodiment of the present invention will be explained by referring to Figs. 4 to 7. As shown in Fig. 4, $Q_1$ and $Q_2$ are MOS transistors in an input circuit as shown in Fig. 2A, the $\overline{WE}$ signal applied to a terminal pin of the memory chip is input to the gate of the transistor $Q_2$. The output of the node $N_1$ is applied to a clock pulse generator circuit 31 in the writing system so that various clocks are generated and these are input to the writing circuit 32. RST designates a reset signal for stopping the generation of the clock in the circuit 31. In the present invention, a transistor $Q_3$ is connected in parallel to the transistor $Q_2$ in the input circuit 21,

and a signal $\phi_D$ is applied to the gate of this transistor (e.g, enhancement type MOS transistor)-$Q_3$. The signal $\phi_D$ may be ① the same as the input signal $\phi_S$ of the driving circuit 22, or ②, a signal which rises together with $\phi_S$ and falls thereafter (at a time when the rise of potential of the wiring $l_2$ of the power source line has finished). Two kinds of memory exist, that is, one in which when the output stage transistor $Q_{12}$ or $Q_{11}$ is turned ON (the state which the output is held), the $\overline{WE}$ signal will not be received even if the $\overline{WE}$ signal is input (or varied), and only when both the output transistors $Q_{11}$ and $Q_{12}$ are turned OFF, the $\overline{WE}$ signal can be received; and the other in which even when the output stage transistor $Q_{12}$ or $Q_{11}$ is turned ON, the $\overline{WE}$ signal is received and the write operation becomes possible. The former may be supplied with signal ①, and the latter with ② mentioned above. Figure 5 shows a circuit for generating the signal $\phi_D$ of type ② mentioned above.

In Fig. 5, $Q_{21} \sim Q_{31}$ are MOS transistors, and these transistors are connected between the power source lines $V_{CC}$ and $V_{SS}$. $\phi_S$ and $\phi_R$ are a set signal and a reset signal supplied to the driving circuit 23 as mentioned above, and in the present circuit, they are supplied to the transistors $Q_{24}$ and $Q_{26}$ and the transistors $Q_{21}$, $Q_{27}$, and $Q_{28}$.

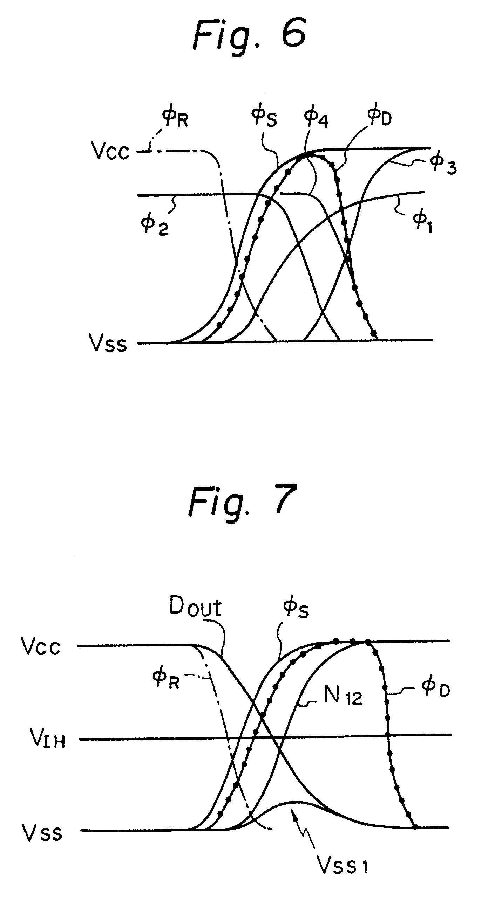

The operation of the circuit will be explained by referring to Fig. 6. When the signal $\phi_S$ rises and $\phi_R$ falls (and the cell data changes from "1" to "0"), the output $D_{OUT}$ falls, as already mentioned. Until that time, as the signal $\phi_R$ is H and $\phi_S$ is L, the transistors $Q_{21}$, $Q_{27}$ and $Q_{28}$ are turned ON, the transistors $Q_{26}$ and $Q_{29}$ are turned OFF, the transistor $Q_{31}$ is turned ON, the signal $\phi_3$ is L, and the transistors $Q_{22}$ and $Q_{25}$ are turned OFF. Further, because the transistor $Q_{23}$ is turned ON, the transistor $Q_{24}$ is turned ON, and because the signal $\phi_S$ is L, the signal $\phi_D$ is also L. The capacitor C is charged up from the power source $V_{CC}$ at the interconnection node between transistors $Q_{28}$ and $Q_{29}$ as the positive side.

In this state, when the signal $\phi_S$ rises and the signal $\phi_R$ falls, the signal $\phi_D$ rises together with the signal $\phi_S$ via the transistor $Q_{24}$, which is still turned ON. Further, the transistors $Q_{27}$ and $Q_{28}$ turn OFF and the transistor $Q_{26}$ turns ON, so that the potential at a node $\phi_1$ rises. Accordingly, at first the transistor $Q_{31}$ is maintained in an ON state until the transistor $Q_{29}$ turns ON and the signal $\phi_3$ is also maintained at the L level. When the transistor $Q_{29}$ turns ON (discharging the capacitor C), the potential at a node $\phi_2$ (gradually) falls, the transistor $Q_{31}$ then turns OFF, and the potential at a node $\phi_3$ rises. When the signal $\phi_3$ rises, the transistors $Q_{22}$ and $Q_{25}$ turn ON, the potential at a node $\phi_4$ falls, and the signal $\phi_D$ also falls. Thus, the signal $\phi_D$

rises together with the rise of the signal $\phi_S$, then falls so that a temporarily generated pulse is formed. The generating period of this pulse can be set by the capacity of the capacitor C.

The pulse of the signal $\phi_D$ applied to transistor $Q_3$ in the input circuit causes transistor $Q_3$ to turn ON. For example, the high level portion of the pulse is at $V_{CC}$ level and so is sufficient to turn on $Q_3$ even during the temporary level change $V_{SS1}$ of the reference potential $V_{SS}$. The high level portion of the pulse continues after the level change $V_{SS1}$ has subsided, the duration of the pulse being determined by the capacitor C.

The switching ON of transistor $Q_3$ ensures that the node $N_1$ generates an L output at the appropriate time, so that the writing mode is released and a writing error does not occur. Reading of data, under control of the signal $\phi_S$, may then be performed correctly.

A similar effect can be achieved by applying a signal $\phi_D$ of type ① , the same as clock signal $\phi_S$, to the transistor $Q_3$. In a type of memory device in which the $\overline{WE}$ signal may be received even when an output transistor $Q_{11}$ or $Q_{12}$ of the data output buffer is ON, it is preferable to maintain $Q_2$ in an ON state throughout the period in which the setting clock signal $\phi_S$ is high, so as to ensure that the writing mode is not set erroneously due to a change in the reference potential $V_{SS}$ or write enable bar signal $\overline{WE}$. Accordingly, a signal of type ① may be used.

Figure 7 is similar to Fig.6, and shows the level change of the output $D_{OUT}$, $V_{SS}$, etc., and that the width of the signal $\phi_D$ is selected to be larger than the period of the level change $V_{SS1}$.

Since the level change at the $V_{SS}$ line $\ell_2$ is also applied to other circuits of the memory, it is possible to provide such an inhibiting circuit as described above for other input circuits which may possibly suffer from such level change and generate malfunctions.

Also, when the input logic level is defined with respect to the reference potential level supplied by the high level power source voltage, a circuit in accordance with the present invention may be employed to overcome the effect of a fall in potential at the reference potential line occurring when the high level is output at the output stage.

As mentioned above, according to the present invention, malfunction of the external control signal input circuit due to a level change in the $V_{SS}$ wiring can be prevented so as to contribute to an improvement of the reliability of a MOS memory device.

**Claims**

1. A semiconductor memory device operatively connectable to a power source including:
   a reference potential line ($\ell_2$) operatively connected to receive a reference potential ($V_{SS}$) from said power source;
   an input circuit ($Q_1$,$Q_2$) connected to said reference potential line ( $\ell_2$ ) and receiving an external input signal ( $\overline{WE}$ ) having a logic level defined in reference to said reference potential ($V_{SS}$) to be supplied to said reference potential line;
   an output circuit ($Q_{11}$,$Q_{12}$) having an external output terminal ($D_{OUT}$), connected to said reference potential line ( $\ell_2$ ), for generating an output indicative of read-out data from the memory device to said external output terminal ($D_{OUT}$); characterised by:
   the generation of the output being initiated at a delay time after a read access to the memory device is made and thereafter the output being maintained; and by
   an inhibiting circuit ($Q_3$) for inhibiting a response to said external input signal ( $\overline{WE}$ ) of said input circuit ($Q_1$,$Q_2$) for a predetermined period during which the generation of the output is initiated at said delay time after said read access, the input circuit
   ($Q_1$,$Q_2$) being enabled thereafter.

2. A semiconductor memory device according to claim 1, wherein said input circuit ($Q_1$,$Q_2$) provides a MOS transistor ($Q_2$) which receives a write enable bar signal ( $\overline{WE}$ ) having a TTL level and outputs an inverted signal of said write enable bar signal having a MOS level, said output circuit ($Q_{11}$,$Q_{12}$) provides an output stage transistor ($Q_{12}$) connected to the reference potential line ( $\ell_2$ ) and outputs a low level output by turning said output stage transistor ($Q_{12}$) ON, and said inhibiting circuit is formed by a transistor ($Q_3$) which is connected in parallel with said MOS transistor ($Q_2$) in said input circuit and which turns ON for a predetermined period during which said output transistor turns ON.

3. A semiconductor memory device as claimed in claim 1 or 2, wherein said inhibiting circuit ($Q_3$) is controlled by a clock signal ($\phi_S$) of the device.

4. A semiconductor memory device as claimed in claim 1 or 2, wherein said inhibiting circuit is controlled by a pulse signal ($\phi_D$) of a duration longer than said temporary change in the reference potential but shorter than a clock pulse of a clock signal ($\phi_S$) of the device.

**5.** A semiconductor memory device as claimed in claim 2, wherein said reference potential is a low MOS level potential ($V_{SS}$).

## Revendications

**1.** Dispositif de mémoire à semiconducteur connectable activement à une source d'alimentation incluant:

une ligne de potentiel de référence ($\ell_2$) connectée activement pour recevoir un potentiel de référence ($V_{SS}$) de la source d'alimentation;

un circuit d'entrée ($Q_1,Q_2$) connecté à la ligne de potentiel de référence ($\ell_2$) et recevant un signal d'entrée externe ($\overline{WE}$) ayant un niveau logique défini en référence au potentiel de référence au potentiel de référence ($V_{SS}$) à fournir à la ligne de potentiel de référence;

un circuit de sortie ($Q_{11},Q_{12}$) ayant une borne de sortie extérieure ($D_{OUT}$), connectée à la ligne de potentiel de référence ($\ell_2$), pour engendrer un signal de sortie indiquant une donnée de lecture provenant du dispositif de mémoire envoyé à la borne de sortie extérieure ($D_{OUT}$); caractérisé par:

la génération du signal de sortie étant déclenchée avec un retard de temps après qu'un accès de lecture au dispositif de mémoire ait été fait et le signal de sortie étant maintenu après cela; et par

un circuit d'interdiction ($Q_3$) pour interdire une réponse au signal d'entrée externe ($\overline{WE}$) du circuit d'entrée ($Q_1,Q_2$) pendant une période prédéterminée où la génération du signal de sortie est déclenchée avec un retard de temps après l'accès de lecture, le circuit d'entrée ($Q_1,Q_2$) étant validé après cela.

**2.** Dispositif de mémoire à semiconducteur selon la revendication 1, dans lequel le circuit d'entrée ($Q_1,Q_2$) fournit un transistor MOS ($Q_2$) qui reçoit un signal de validation d'écriture barre ($\overline{WE}$) ayant un niveau de logique à transistor-transistor TTL et engendre en sortie un signal inversé du signal de validation d'écriture barre ayant un niveau MOS, le circuit de sortie ($Q_{11},Q_{12}$) fournit un transistor d'étage de sortie ($Q_{12}$) connecté à la ligne de potentiel de référence ($\ell_2$) et engendre en sortie un signal de sortie de niveau bas en rendant conducteur le transistor d'étage de sortie ($Q_{12}$), et le circuit d'interdiction est formé par un transistor ($Q_3$) qui est connecté en parallèle avec le transistor MOS ($Q_2$) dans le circuit d'entrée et qui est rendu conducteur pendant une période prédéterminée où le transistor de sortie est rendu conducteur.

**3.** Dispositif de mémoire à semiconducteur selon l'une quelconque des revendications 1 et 2, dans lequel le circuit d'interdiction ($Q_3$) est commandé par un signal d'horloge ($\phi_S$) du dispositif.

**4.** Dispositif de mémoire à semiconducteur selon l'une quelconque des revendications 1 et 2, dans lequel le circuit d'interdiction est commandé par un signal pulsé ($\phi_D$) d'une durée supérieure au changement temporaire du potentiel de référence mais inférieure a une impulsion d'horloge d'un signal d'horloge ($\phi_S$) du dispositif.

**5.** Dispositif de mémoire à semiconducteur selon la revendication 2, dans lequel le potentiel de référence est un potentiel de niveau MOS bas ($V_{SS}$).

## Ansprüche

**1.** Halbleiterspeichervorrichtung, die operativ mit einer Energiequelle verbindbar ist, mit:

einer Referenzpotentialleitung ($l_2$), die operativ angeschlossen ist, um ein Referenzpotential ($V_{SS}$) von der genannten Energiequelle zu empfangen;

einer Eingangsschaltung ($Q_1,Q_2$), die mit der genannten Referenzpotentialleitung ($l_2$) verbunden ist und ein externes Eingangssignal ($\overline{WE}$) empfängt, das einen Logikpegel hat, der in Bezug auf das genannte Referenzpotential ($V_{SS}$), das der genannten Referenzpotentialleitung zuzuführen ist, definiert ist;

einer Ausgangsschaltung ($Q_{11}$, $Q_{12}$), die einen externen Ausgangsanschluß ($D_{OUT}$) hat, der mit der genannten Referenzpotentialleitung ($l_2$) verbunden ist, um einen Ausgang zu erzeugen, der von der Speichervorrichtung zu dem genannten externen Ausgangsanschluß ($D_{OUT}$) ausgelesene Daten anzeigt;

gekennzeichnet durch;

das Initiieren der Erzeugung des Ausgangs zu einer Verzögerungszeit, nachdem ein Lesezugriff zu der Speichervorrichtung durchgeführt wird, durchgeführt, und danach wird der Ausgang aufrechterhalten; und durch

eine Sperrschaltung ($Q_3$) zum Sperren einer Antwort auf das genannte externe Eingangssignal ($\overline{WE}$) der genannten Eingangsschaltung ($Q_1$, $Q_2$), für eine bestimmte Periode, während welcher die Erzeugung des Ausgangs zu der genannten Verzögerungszeit nach dem genannten Lesezugriff initiiert wird, und danach wird die Eingangsschaltung ($Q_1$, $Q_2$) freigegeben.

2. Halbleiterspeichervorrichtung nach Anspruch 1, bei der die genannte Eingangsschaltung ($Q_1$, $Q_2$) einen MOS-Transistor ($Q_2$) aufweist, der ein Schreibfreigabe-Bar signal ($\overline{WE}$) empfängt, das einen TTL-Pegel hat und ein invertiertes Signal des genannten Schreibfreigabe-Bar signals ausgibt, das einen MOS-Pegel hat, wobei die Ausgangsschaltung ($Q_{11}$, $Q_{12}$) einen Ausgangsstufentransistor ($Q_{12}$) aufweist, der mit der Referenzpotentialleitung ($l_2$) verbunden ist, und einen niedrigen Pegel ausgibt, der durch EIN-Schalten des genannten Ausgangsstufentransistors ($Q_{12}$) ausgegeben wird, und die genannte Sperrschaltung durch einen Transistor ($Q_3$) gebildet wird, der parallel zu dem genannten MOS-Transistor ($Q_2$) in der genannten Eingangsschaltung verbunden ist, und der für eine vorbestimmte Zeitperiode, während welcher der genannte Ausgangstransistor auf EIN schaltet, auf EIN schaltet.

3. Halbleiterspeichervorrichtung nach Anspruch 1 oder 2, bei der die genannte Sperrschaltung ($Q_3$) durch ein Taktsignal ($\Phi_S$) der Vorrichtung gesteuert wird.

4. Halbleiterspeichervorrichtung nach Anspruch 1 oder 2, bei der die genannte Sperrschaltung durch ein Impulssignal ($\Phi_D$) von einer Dauer gesteuert wird, die länger als die genannte temporäre Änderung in dem Referenzpotential, jedoch kürzer als ein Taktimpuls eines Taktsignals ($\Phi_S$) der Vorrichtung,ist.

5. Halbleiterspeichervorrichtung nach Anspruch 2, bei der das genannte Referenzpotential ein niedriges MOS-Pegelpotential ($V_{SS}$) ist.

# Fig. I

EP 0 181 177 B1

# Fig. 2A

*Fig. 2B*

*Fig. 3*

# Fig. 4

EP 0 181 177 B1

Fig. 5

## Fig. 6

## Fig. 7